Europäisches Patentamt

European Patent Office

Office européen des brevets

(11) Veröffentlichungsnummer: **0 505 415 B1**

(12) **EUROPÄISCHE PATENTSCHRIFT**

(45) Veröffentlichungstag der Patentschrift: **27.07.94**

(51) Int. Cl.5: **H03K 5/153**, H03K 5/156, H03K 5/24

(21) Anmeldenummer: **91900766.6**

(22) Anmeldetag: **01.12.90**

(86) Internationale Anmeldenummer: **PCT/EP90/02068**

(87) Internationale Veröffentlichungsnummer: **WO 91/09469 (27.06.91 91/14)**

(54) **SCHALTUNG ZUR ERZEUGUNG EINER TAKTIMPULSFOLGE.**

(30) Priorität: **12.12.89 DE 3940999**

(43) Veröffentlichungstag der Anmeldung: **30.09.92 Patentblatt 92/40**

(45) Bekanntmachung des Hinweises auf die Patenterteilung: **27.07.94 Patentblatt 94/30**

(84) Benannte Vertragsstaaten: **AT BE CH DE DK ES FR GB GR IT LI LU NL SE**

(56) Entgegenhaltungen: **GB-A- 2 095 064**

**Patent Abstract of Japan, vol.5, no.59 (E-53)(731) 22 April 1981 & JP-A-5610721**

**Electronics, vol.49, no.4 19 February 1976 (New York US) P.Sherrod: "Comparator circuit makes versatile Schmitt trigger", pages 128-129**

(73) Patentinhaber: **Deutsche Thomson-Brandt GmbH
Hermann-Schwer-Strasse 3
Postfach 1307
D-78003 Villingen-Schwenningen(DE)**

(72) Erfinder: **GLEIM, Günter
Oberer Sonnenbühl 22
D-7730 VS-Villingen(DE)**
Erfinder: **HEIZMANN, Friedrich
Höfenstr. 30
D-7730 VS-Obereschach(DE)**

(74) Vertreter: **Einsel, Robert, Dipl.-Ing.
Deutsche Thomson-Brandt GmbH
Patent- und Lizenzabteilung
Göttinger Chaussee 76
D-30453 Hannover (DE)**

Patent Abstract of Japan vol.8, no.149 (E-255)(1586) 12 July 1984 & JP-A-5954320

Patent Abstract of Japan vol.3, no.85 (E-124) 21 July 1979 & JP-A-5461863

Patent Abstract of Japan vol.12, no.469 (E-691)(3316) 8 december 1988 & JP-A-63191410

Patent Abstract of Japan vol.8, no.256 (E-280)(1693) 22 November 1984 & JP-A-59128822

## Beschreibung

Die Erfindung geht aus von einer Schaltung zur Erzeugung einer Taktimpulsfolge gemäß dem Oberbegriff des Anspruchs 1. Eine derartige Schaltung ist bekannt aus der PATENT ABSTRACT OF JAPAN, Band 5, Nr. 59 (E-53) (731), 22. April 1981; & JP-A-56 10721.

Eine derartidge Taktimpulsfolge wird als sogenannter Systemtakt in größeren digitalen Systemen benötigt, z. B. zur gleichzeitigen Ansteuerung von A/D-Wandlern, D/A-Wandlern, Decodern, Speichern und dergleichen. Die Taktimpulsfolge wird z. B. aus einem ankommenden Einganssignal mittels einer Kippschaltung mit Schwellwerteigenschaft erzeugt. Das Eingangssignal kann in der Praxis größere Amplitudenschwankungen aufweisen, z. B. wenn es von einer Übertragungsstrecke oder einem Magnetbandgerät geliefert wird. Wenn die Amplitude des Eingangssignals in die Nähe des Schwellwertes der die Taktimpulsfolge erzeugenden Kippschaltung kommt, Können innerhalb der Taktimpulsfolge Impulse sehr kurzer Dauer von nur wenigen ns auftreten. Andererseits benötigen digitale Schaltungen für eine einwandfreie Ansteuerung Steuerimpulse mit einer Mindestimpulsbreite. Unterhalb einer derartigen Mindestimpulsbreite kann der Fall eintreten, daß die gesteuerten Schaltungen gar nicht mehr oder indifferent arbeiten. Außerdem kann bei einer sehr geringen impulsbreite aufgrund der endlichen Flankendauer eine Verringerung der Amplitude auftreten.

Der Erfindung liegt die Aufgabe zugrunde, eine Schaltung der beschriebenen Art so weiterzubilden, daß auch bei Amplitudenschwankungen des synchronisierenden Eingangssignals in der erzeugten Taktimpulsfolge entweder gar keine Impulse, oder nur Impulse mit ausreichender Dauer, jedoch keine Impulse mit einer zu kurzen Impulsbreite auftreten.

Diese Aufgabe wird durch die im Anspruch 1 angegebene Erfindung qelöst. Eine vorteilhafte Weiterbildung der Erfindung ist im abhängigen Anspruch angegeben.

Die Erfindung beruht auf folgender Erkenntnis. Die Gefahr eines sehr kurzen Impulses besteht dann, wenn der Maximalwert des Eingangssignales praktisch mit dem Schwellwert der Kippschaltung zusammenfällt. Das beruht darauf, daß dann das Erreichen des Schwellwertes bei ansteigender Amplitude und das Erreichen des Schwellwertes bei abfallender Amplitude des Eingangssignals zeitlich zusammenfallen. Durch die erfindungsgemäße Kippstufe mit einer Hysterese sind jeweils bei ansteigendem Eingangssignal und bei abfallendem Eingangssignal zwei verschieden große Schwellwerte wirksam. Damit ist ausgeschlossen, daß das Erreichen des Schwellwertes bei ansteigender Spannung und bei abfallender Spannung zeitlich zusammenfallen. Das gilt unabhängig von der jeweiligen Amplitude des Eingangssignals. Das Eingangssignal kann niemals gleichzeitig die beiden voneinander abweichenden Schwellwerte erreichen. Dadurch ist sichergestellt, daß in Abhängigkeit von der Amplitude des Eingangssignals entweder in erwünschter Weise gar kein Impuls oder ein Impuls ausreichender Dauer erzeugt wird, Diese Dauer ist abhängig von dem Unterschied in den beiden Schwellwerten.

Durch die Erfindung wird somit auf schaltungstechnisch einfache Weise das Auftreten von unerwünschten sehr kurzen Impulsen verhindert. Die in der Kippstufe mit Hysterese gewonnene Spannung wird mit einer Spannung kombiniert, die in einer Kippstufe ohne Hysterese gewonnen ist. Es kann zwar vorkommen, daß bei der erfindungsgemäßen Schaltung anstelle eines unerwünschten kurzen Impulses gar kein Impuls erzeugt wird. Das ist jedoch nicht nachteilig. Allenfalls wird das Arbeiten des Gesamtsystems kurzeitig verlangsamt, wobei jedoch die genannten Störungen durch zu kurze Impulse vermieden werden.

Die Erfindung wird anhand der Zeichnung erläutert. Darin zeigen

Fig. 1     die Wirkungsweise anhand von Impulsdiagrammen,

Fig. 2     ein Blockschaltbild für ein Ausführungsbeispiel,

Fig. 3     ein Blockschaltbild für eine Schaltung zur Erzeugung einer Taktimpulsfolge und

Fig. 4     Impulsdiagramme für Fig. 3.

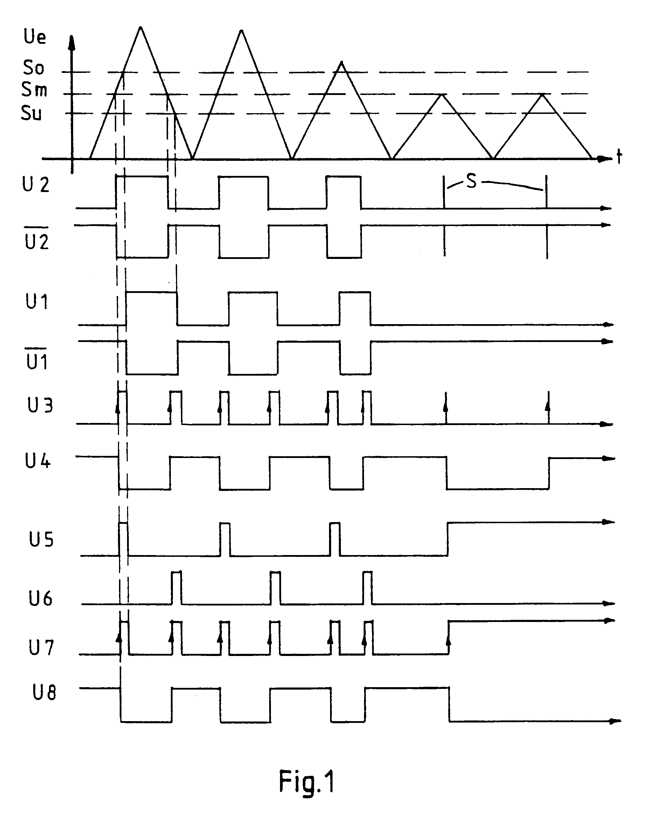

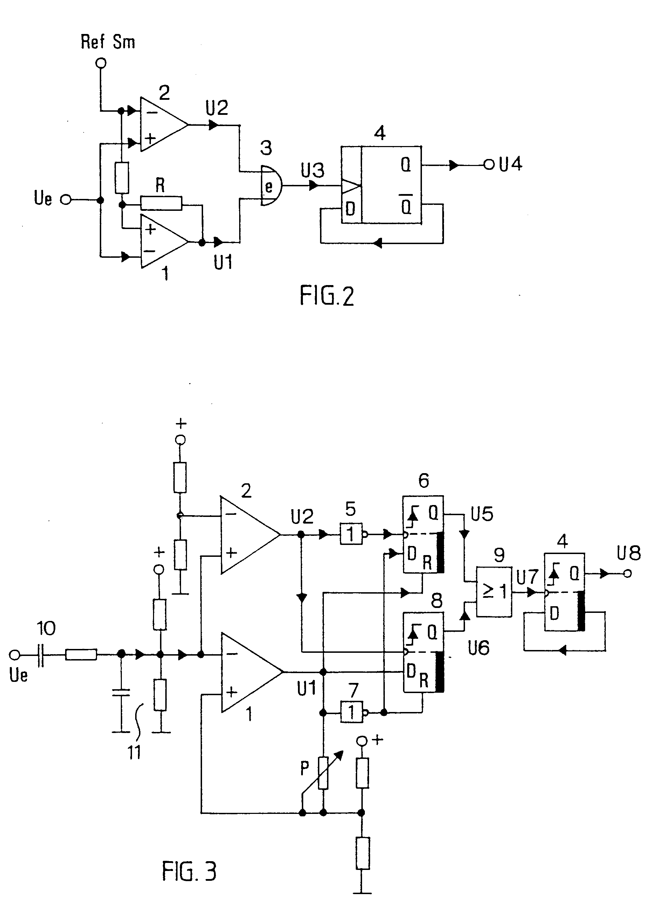

In Fig. 1, 2 liegt an einer Eingangsklemme ein Eingangssignal Ue, das Amplitudenschwankungen unterworfen ist und aus dem ein Taktsignal konstanter Amplitude und ohne kurze Spannungsspitzen erzeugt werden soll. Ue gelangt an den Eingang des Komparators 2, an dessen anderen Eingang eine Referenzspannung Ref mit dem Wert Sm angelegt ist. Der Komparator 2 bildet eine Schwellwertschaltung, die bei ansteigender und abfallender Spannung Ue bei demselben Schwellwert Sm anspricht. Dadurch entsteht am Ausgang die Spannung U2 mit dem Wert "1" jeweils für den Zeitraum, in dem Ue oberhalb von Sm liegt. Wenn durch einen Amplitudenabfall der Maximalwert von Ue in die Nähe des Schwellwertes Sm kommt, fallen das Überschreiten und das Unterschreiten des Schwellwertes zeitlich zusammen. Es entstehen dann sehr kurze Impulse S. Derartige Impulse S sehr kurzer Dauer reichen nicht aus, mit Sicherheit digitale Schaltungen auszulösen, und sollen daher vermieden werden. Ue gelangt außerdem auf den Komparator 1, der eine positive Rückkopplung mit dem Widerstand R aufweist. Die Anspruchschwelle der Komparatoren 1, 2 wird durch die Rückkopplung mit einem Widerstand vom Ausgang zu einem Eingang jeweils geändert. Die Rückkopplung wirkt in Fig. 2 als Mitkopplung, da sie auf den positiven Eingang des Komparators 1 wirkt. Die Mitkopplung über R bewirkt, daß der Komparator 1 bei ansteigender Spannung bei einem oberen Schwellwert So und bei abfallender Spannung bei einem davon abweichenden unteren Schwellwert Su anspricht und die Ausgangsspannung U1 abgibt. In U1 sind die störenden Impulse S schon nicht mehr enthalten, weil bei einer Amplitude von Ue = Sm der Schwellwert So nicht erreicht wird. Die Spannung U1 kann daher als Taktimpulsfolge ohne störende Impulse S oder zur Erzeugung einer derartigen Taktimpulsfolge verwendet werden. Die Spannungen U1, U2 gelangen auf das EXKLUSIVE-ODER-Gatter 3, an dessen Ausgang die Spannung U3 steht. U3 gelangt auf den Takteingang des flankengetriggerten D-Flip Flop 4, dessen Ausgang $\overline{Q}$ mit dem Rücksetzeingang D verbunden ist. Das Flip Flop 4 dient als Frequenzteiler und erzeugt die Spannung U4. U4 enthält nicht mehr die störenden kurzen Impulse S und kann als Taktimpulsfolge in einem digitalen System verwendet werden.

Die Schaltung gemäß Fig. 2 erzeugt somit, wie in Fig. 1 gezeigt, einen Systemtakt mit halber Frequenz. Diese halbe Frequenz ist in manchen Fällen nicht störend, kann jedoch in anderen Fällen unerwünscht sein. Dieser halbe Systemtakt wird durch die Schaltung gemäß Fig. 3 vermieden. Der halbe Systemtakt hat den Nachteil, daß die Schaltung dann entsprechend langsamer arbeitet.

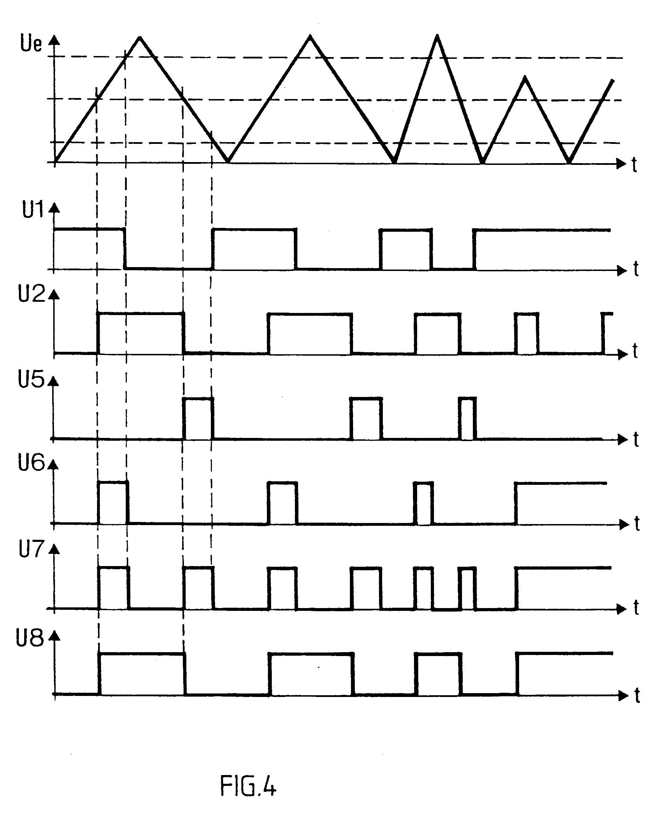

Die Wirkungsweise der Schaltung gemäß Fig. 3 wird anhand der Impulsdiagramme in Fig. 4 erläutert. Duch den Kondensator 10 am Eingang werden Gleichspannungsanteile und niederfrequente Störungen unterdrückt. Durch das folgende RC-Glied 11 werden Störspitzen unterdrückt und Kanten von Rechteck-Eingangssignalen abgerundet. Der Komparator 1 mit der Ausgangsspannung U1 arbeitet in der beschriebenen Weise mit Hysterese, die mit dem Potentiometer P einstellbar ist. Der Komparator 2 mit der Ausgangsspannung U2 arbeitet ohne Hysterese. Durch die unterschiedlichen Schaltschwellen des Komparators 1 und des Komparators 2 wird eine zeitliche Überschneidung der Signale U1 und U2 erreicht. Die beiden Flip Flop 6, 8 mit den Ausgangssignalen U5 und U6 sprechen auf die Signale U1, U2 an. U5 geht auf High, wenn U2 auf Low geht, und geht auf Low, wenn U1 auf High geht. U6 geht auf High, wenn U2 auf High geht, und geht auf Low, wenn U1 auf L geht. Wenn einer der Komparatoren 1, 2 nicht mehr schaltet, werden die Flip Flop 6, 8 stillgesetzt und geben somit keine Ausgangsspannungen U5, U6 mehr ab. Das ODER-Glied 9 verknüpft die Impulse U5, U6, deren Frequenz durch das Flip Flop 4 wieder halbiert wird, so daß das Ausgangssignal U8 entsteht. Da die positiven Flanken von U7 immer von U2 geliefert werden, arbeitet U8 nur auf U2, d.h. auf das Ausgangssignal des Komparators 2 ohne Hysterese. Das RC-Glied 11 in Fig. 3 hat noch folgenden Zweck. Wenn das Eingangssignal am Eingang des Komparators 1 sehr steile Flanken hat, können die Anspruchsschwellen der Komparatoren 1, 2 zusammenfallen. Deshalb ist es dann vorteilhaft, das Signal am Eingang eines Komparators 1 zu verzögern, d.h. die Flanke des anliegenden Eingangssignals mit einem Kondensator absichtlich abzuflachen. Es wird dann künstlich das dreieckförmige oder sinusförmige Signal Ue gemäß Fig. 1 erzeugt.

**Patentansprüche**

1. Schaltung zur Erzeugung einer Taktimpulsfolge aus einem periodischen Eingangssignal (Ue), bei der das Eingangssignal (Ue) einer Schwellwertstufe (1) zugeführt ist, die im Sinne einer Hysterese bei ansteigender Spannung (Ue) bei einem ersten Schwellwert (So) und bei abfallender Spannung (Ue) bei einem anderen, zweiten Schwellwert (Su) anspricht, das Eingangssignal (Ue) außerdem an eine zweite Schwellwertstufe (2) mit einem dritten Schwellwert (Sm) ohne Hysterese angelegt ist, der erste Schwellwert (So) oberhalb und der zweite Schwellwert (Su) unterhalb des dritten Schwellwertes (Sm) liegt und die Ausgangsspannungen (U1, U2) der beiden Stufen (1, 2) an die Eingänge eines EXOR-Gatters (3) angelegt sind, dessen Ausgang mit dem Eingang einer bistabilen Kippstufe (4) verbunden ist, an deren Takteingang das Ausgangssignal (U3) des EXOR-Gatters (3) angelegt ist, **dadurch gekennzeichnet**, daß die Kippstufe (4) als Frequenzteiler ausgebildet ist, deren Ausgang ($\overline{Q}$) mit deren Rücksetzeingang (D) verbunden ist.

2. Schaltung nach Anspruch 1, **dadurch gekennzeichnet**, daß die Schwellwertstufe (1) mit Hysterese durch einen Komparator (1) gebildet ist, an dessen ersten Eingang (-) das Eingangssignal (Ue) angelegt und dessen anderer Eingang (+) über einen Rückkopplungsweg (R) mit dem Ausgang verbunden ist.

**Claims**

1. A circuit for the generation of a clock pulse sequence from a periodic input signal (Ue) wherein the input signal (Ue) is supplied to a threshold value stage (1) which with hysteresis responds at a first threshold value (So) in the case of increasing voltage (Ue) and responds at another, second threshold value (Su) in the case of reducing voltage (Ue), the input signal (Ue) is additionally applied to a second threshold value stage (2) with a third threshold value (Sm) without hysteresis, the first threshold value (So) is above and the second threshold value (Su) is below the third threshold value (Sm), and the output voltages (U1, U2) of the two stages (1, 2) are applied to the inputs of an exclusive-OR-gate (3), the output of which is connected to the input of a bistable circuit (4), to the clock input of which the output signal (U3) of the exclusive-OR-gate (3) is applied, characterised in that the bistable circuit (4) is constructed as a frequency divider, the output ($\overline{Q}$) of which is connected to its resetting input (D).

2. A circuit as claimed in Claim 1, characterised in that the threshold value stage (1) with hysteresis is formed by a comparator (1), to the first input (-) of which the input signal (Ue) is applied and the other input (+) of which is connected via a feedback path (R) to the output.

**Revendications**

1. Circuit pour produire une séquence d'impulsions de cycle à partir d'un signal d'entrée périodique (Ue) dans lequel le signal d'entrée (Ue) est amené à un étage de valeur seuil (1) qui est excité, dans l'esprit d'une hystérésis, lors de la tension croissante (Ue) pour une première valeur seuil (So) et, lors de la tension décroissante (Ue), pour une autre, une seconde valeur de seuil (Su), dans lequel le signal d'entrée (Ue) est en plus appliqué à un second étage de valeur seuil (2) avec une troisième valeur seuil (Sm) sans hystérésis, la première valeur seuil (So) se situant au-dessus et la seconde valeur seuil (Su) se situant au-dessous de la troisième valeur seuil (Sm) et les tensions de sortie (U1, U2) des deux étages (1, 2) étant appliquées aux entrées d'un élément OU exclusif (3) dont la sortie est reliée à l'entrée d'une bascule bistable (4), à l'entrée de cycle de laquelle le signal de sortie (U3) de l'élément OU exclusif (3) est appliqué, **caractérisé en ce** que l'étage à bascule (4) est configuré comme un diviseur de fréquence dont la sortie ($\overline{Q}$) est reliée à l'entrée de remise à l'état initial (D).

2. Circuit selon la revendication 1, **caractérisé en ce** que l'étage de valeur seuil (1) avec hystérésis est formé par un comparateur (1), à la première entrée (-) duquel le signal d'entrée (Ue) est appliqué et dont l'autre entrée (+) est reliée par une voie de réaction (R) à la sortie.

Fig.1

FIG.2

FIG. 3

FIG.4